(19) **Europäisches Patentamt**
**European Patent Office**
**Office européen des brevets**

(11) **EP 2 137 771 B1**

(12) **EUROPEAN PATENT SPECIFICATION**

(45) Date of publication and mention
of the grant of the patent:
**04.01.2017 Bulletin 2017/01**

(21) Application number: **08736480.8**

(22) Date of filing: **23.04.2008**

(51) Int Cl.:
*H01L 31/075* [(2012.01)]    *H01L 31/18* [(2006.01)]

(86) International application number:
**PCT/EP2008/054896**

(87) International publication number:
**WO 2008/132104 (06.11.2008 Gazette 2008/45)**

(54) **PHOTOVOLTAIC MODULE COMPRISING LAYER WITH CONDUCTING SPOTS**

PHOTOVOLTAISCHES MODUL MIT EINER SCHICHT MIT LEITENDEN FLECKEN

MODULE PHOTOVOLTAÏQUE COMPRENANT UNE COUCHE DOTÉE DE POINTS CONDUCTEURS

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **26.04.2007 EP 07107029**

(43) Date of publication of application:
**30.12.2009 Bulletin 2009/53**

(73) Proprietor: **HyET Energy Systems B.V.**
**6827 AV Arnhem (NL)**

(72) Inventors:
 • **DUBBELDAM, Gerrit Cornelis**
   **NL-6904 PH Zevenaar (NL)**
 • **SPORTEL, Edwin Peter**
   **NL-6846 CE Arnhem (NL)**

(74) Representative: **Hesselink, Dinah Elisabeth et al**
**De Vries & Metman**
**Overschiestraat 180**
**1062 XK Amsterdam (NL)**

(56) References cited:
**US-A- 5 810 945**

 • **TOET D ET AL: "Large area polycrystalline silicon thin films grown by laser-induced nucleation and solid phase crystallization" THIN SOLID FILMS, ELSEVIER-SEQUOIA S.A. LAUSANNE, CH, vol. 296, no. 1-2, March 1997 (1997-03), pages 49-52, XP004080952 ISSN: 0040-6090**
 • **WOHLGEMUTH J ET AL: "Hot spot tests for crystalline silicon modules" PHOTOVOLTAIC SPECIALISTS CONFERENCE, 2005. CONFERENCE RECORD OF THE THIRTY-FIRST IEEE LAKE BUENA VISTA, FL, USA 3-7 JAN. 2005, PISCATAWAY, NJ, USA,IEEE, US, 3 January 2005 (2005-01-03), pages 1062-1063, XP010822950 ISBN: 0-7803-8707-4**

**Description**

The invention relates to a photovoltaic (PV) module comprising a plurality of cells, each cell containing a substrate, a transparent conductor layer, a photovoltaic layer, and a back-electrode layer, wherein the photovoltaic layer comprises at least one p-i-n or n-i-p silicon layer, and to a method of making said photovoltaic module.

When a PV module consisting of many series connected cells is partly shaded, the illuminated cells may cause a strong negative (reverse) voltage over the shaded cells. That is particularly the case when the shaded cells have a high parallel resistance. Because no current is generated in the shaded cells, the module current is almost zero so that the shaded cells are exposed to the open-circuit voltage of the illuminated cells. With large systems such voltage may be very high so that the break-down voltage is easily passed. In the shaded cells a strong local heat production can occur (hot spot) which may result to local damage of the shaded cell. In the worst case, these hot spots may cause fire.

The most common remedy for preventing hot spots is the application of by-pass diodes that start conducting at a relative low voltage in one direction and that isolate in the other direction, as has been described in US 5,223,044 and WO 2005/101511. However the application of by-pass diodes is expensive. Particularly with thin-film PV modules that have a relatively low break-down voltage (typical < 8V) the number of cells that can be protected per by-pass diode is small, i.e. about less than 10 for thin film a-Si.

In the case of thin-film PV-modules, monolithic by-pass diodes can be made at the cost of a very complex process for serves connection.

Another method is the application of so-called PV-shunts, as was described in US 2003/0159728. According to this method several modules that consist of series connected cells are connected in parallel. When one module is partly shaded the reverse voltage over the shaded cells is decreased with the voltage of the fully illuminated modules. However combined series and parallel connections decreases the system voltage and increases the system current and it limits the freedom of design of the system.

In EP 1 079 441 a method for adapting the IV characteristic of a partly shaded PV module was described. According to this method the cells are exposed to an increasing biased AC voltage until the current starts to increase. After the treatment the cells show a non-linear conduction that permits a shaded cell conducting the short-circuit current of the illuminated cells at a relatively low voltage. However this method depends on the presence of accidental spots in the PV cell where the non-linear conduction can be introduced. Moreover direct contact with all cells is necessary.

US 5,810,945 describes a method of fabricating an electronic micropatterned device, in particular a solar cell, in which at least one of the electrodes is provided with a pattern. The problem of shading is not addressed in this reference.

Toet et al. (D. Toet et al., Thin solid films 296 (1977) 49-52) describes a two-step technique for the growth of polycrystalline silicon thin films on glass substrates. The problem of shading is not addressed.

Wohlgemuth et al. (J. Wohlgemuth and W. Herrmann, Hot spot test for crystalline silicon modules, Photovoltaic Specialists Conference, 2005, Piscataway, NJ, USA 3-7 January 2005, IEEE, US, January 3, 2005, pages 1062-1063) describes methods for performing hot spot tests. The prevention of the formation of hot spots is not discussed.

It is therefore an object of the present invention to provide a remedy for preventing hot spots that does not show any of the disadvantages mentioned above, and which can be applied in an easy and cheap manner. It was now found that this objective could be reached by adapting the IV characteristics of the thin-film PV cells by introducing identical well defined non-linear conducting spots at precisely defined positions. To this end the invention pertains to a photovoltaic (PV) module according to claim 1 comprising a plurality of cells, each cell containing a substrate, a transparent conductor electrode layer, a photovoltaic layer, and a back-electrode layer, wherein the photovoltaic layer comprises at least one p-i-n or n-i-p silicon layer, characterized in that said silicon layer comprises 10 to 1000 conducting spots of recrystallized silicon per $cm^2$, each having independently a surface of 10 to 2500 $\mu m^2$, wherein the conducting spots act as non-linear conducting paths between the two electrode layers and wherein, at a voltage of IV, the conductive spots conduct a current per unit of surface of less than 0.2 $mA/cm^2$, and at a voltage of 8V, the conductive spots conduct a current per unit of surface of more than 10 $mA/cm^2$.

This method is based on the fact that most PV cells consist of an active semi-conductor layer having electrode layers en both sides. At least one of these electrode layers is transparent so that light may reach the active layer.

According to the invention the active layer of the PV cell is locally heated so that the layer transforms at least partly into another phase. The transformed material loses the PV characteristics but the semi-conductor properties can be preserved by carefully dosing the amount of heat. As a result the transformed spots act as non-linear conducting paths between the two electrode layers which have a relatively low conductivity at low voltage and a relatively high conductivity at high voltage. More in particular, at a voltage of 1V, the conductive spots conduct a current per unit of surface of less than 0.2 $mA/cm^2$, and at a voltage of 8V, the conductive spots conduct a current per unit of surface of more than 10 $mA/cm^2$.

In the present specification the transformed material will sometimes be indicated as recrystallized silicon, and the formation process will sometimes be indicated as melting followed by recrystallisation. However, this description should in no way be regarded as limiting the nature of the present invention. It will be clear that the crux of the present invention is the presence of conducting spots, and in their formation by way of heat treatment. It does not reside in the crystalline form of the silicium or in whether or not melting or recystallisation takes place.

In order to minimize local heat production many of such non-linear conducting spots must be made so that the current per spot is small.

The current through the non-linear conducting spots can be described as with an odd series expansion:

$$J_{\text{conducting spots}}(V) = \frac{V}{R_1} + \frac{V^3}{R_3} + \frac{V^5}{R_5} + \cdots\cdots \quad (1)$$

Wherein $J_{\text{conducting}}$ spots (V) is the current per unit of surface through the conducting spots at the voltage V [A/cm$^2$]; V is the voltage between the two electrodes [V]; and $1/R_n$ is the nth order coefficient of the series expansion. The dimension of Rn is [Vn.cm2/A].

The part directly around a voltage V=0 is determined mostly by R1, the next part also by R3, etc. For the description of the essential part of the JV curve of a PV cell the coefficients R1 and R3 are sufficient. R1 must be as high as possible because the linear conduction starts causing losses at a low voltage. $R_3$ must be chosen so that the maximum possible current is conducted at a voltage below the break-down voltage.

Without the introduction of the non-linear conducting spots the reverse voltage over a shaded cell may be as high as -19V in the case of a module with 28 cells when the module is shorted ($R_1$-10,000, $R_3$=1,000,000), With a larger number of cells the reverse voltage over the shaded cell increases. That large voltage is far beyond the break down voltage. With the non-linear conducting spots ($R_1$-2,500, $R_3$=10,000) the voltage over a shaded cell is limited to -5V which is below the break-down voltage. $R_1$ shows a related decrease with the introduction of $R_3$. The JV curve under normal conditions (no shading) is hardly affected by the non-linear conducting spots. With an increasing number of cells the reverse voltage over a shaded cell remains about -5V when the module is shorted.

When non-linear conducting spots are applied in all cells of a module so that the p-i-n or n-i-p silicon layer comprises 10 to 1000 conducting spots of recrystallized silicon per cm$^2$ each having independently a surface of 10 to 2500 $\mu$m$^2$, shading does not cause damage regardless the number of series connected cells. Because a large number of regular distributed conducting spots is introduced, the dissipated energy in the shaded cell is also regularly distributed over the PV cell. Excessive heating of a single spot is avoided. The module performance under normal conditions is hardly affected by the non-linear conducting spots.

In a preferred embodiment the PV module has a silicon layer comprising 20 to 500 conducting spots per cm$^2$, more preferably 30 to 300 conducting spots per cm$^2$ still more preferably 80 to 120 conducting spots per cm$^2$. In another preferred embodiment the PV module has a silicon layer wherein the conducting spots have a surface of 30 to 300 $\mu$m$^2$, preferably 50 to 150 $\mu$m$^2$, more preferably 60 to 120 $\mu$m$^2$.

Because the spots do not contribute to current production under normal operating conditions, it is preferred for the total surface area of the conductive spots to be relatively small. More in particular, the ratio of the surface area of the conductive spots to the surface area of the current generating part of the solar cell preferably is less than 0.01:1, more preferably less than 0.001:1. As a preferred minimum value, a ratio of 0.00001:1 may be mentioned.

It is another objective of the invention to provide a method for making the above PV modules. Non-linear conducting spots can be obtained in several ways. One way is obtaining non-linear spots by applying an increasing AC voltage over the cells that are directly contacted with long electrodes. However by doing so the spots are randomly distributed and properties of the spots depend on accidental local conditions of the active layer of the PV cell.

Well defined spots are obtained by bringing a defined amount of energy to the active layer of the PV cell at defined positions. According to a preferred method the p-i-n or n-i-p silicon layer is locally heated at 10 to 1000 spots per cm$^2$, each spot having independently surface of 10 to 2500 $\mu$m$^2$, whereby said silicon is transformed at least partly to another phase at these spots. For instance, this can be carried out with the focused beam of a pulsed laser of which the wavelength is such that it is absorbed in the active layer of the PV cell. With amorphous Si PV cells a frequency doubled Q-switched Nd-YAG, Nd-YFL or Nd-YVO4 laser can be used ($\lambda$=532 nm). The pulse duration of such lasers is short, typical less than 50 ns (nanoseconds), more typically about 15 ns, so that the directly illuminated spot absorbs all energy without losses due to heat conduction. The pulse energy is constant within a narrow range and the diameter of the beam waist in the focus point can be small according to:

$$d = \frac{1.22 \cdot \lambda \cdot F}{D} \quad (2)$$

wherein d is the diameter of the beam waist;

λ is the wavelength of the laser light;

F is the focal length of the focusing lens; and

D is the diameter of the parallel laser beam before entering the lens

With D=5 mm, F=100 mm and λ=532 nm it follows that d=13 μm. If the waist the laser beam has a Gaussian intensity profile so that the sizes of the non-linear spots that are made with the laser are even smaller.

The invention is further illustrated by the following non-limitative description of a specific embodiment of the invention.

Small sized modules (8 cells of 1x7.5 cm$^2$) and larger modules (28 cells of 1x30 cm$^2$) were treated with a pulsed ND-YVO4 laser. A single row of non-linear conducting spots (distance between 2 spots 50 μm) per cell was made.

The laser treatment introduces a non-linear conductance of the cells that can be characterized with the values of $R_n$ of eq. (1). A method for determining $R_n$ is described below. The JV-curves of single cells can be described with the well-know diode equation (see S.R. Wenham et al., Applied Photovoltaics, ISBN 0 36758 909 4, p. 33) which equation is extended with terms for the light induced current and the non-linear parallel resistance:

$$J = J_0 \cdot (e^{\frac{qV}{nkT}} - 1) - J_L + \frac{V}{R_1} + \frac{V^3}{R_3} + \cdots \quad (3)$$

wherein J is the current density [A/m$^2$]

$J_0$ is the dark current density [A/m$^2$]

$J_L$ is the light induced current density [A/m$^2$]

q is elementary charge

k is the Boltzmann constant

n is the diode quality factor

T is the temperature [K]

V is the voltage per cell

The JV curve of a fully illuminated module is only slightly sensitive for varying values of $R_n$ of normal cells. When one of the cells is shaded the JV-curve changes strongly. The light induced current of the shaded cell is (almost) zero. The illuminated cells apply a reverse voltage over the shaded cell that is varied with the external voltage source. The shaded cell acts as sort of load resistance for the illuminated cells of the module. The theoretical JV curves of the illuminated cells are insensitive for $R_n$ when the cells are not strongly shunted. On the contrary the JV curve of the shaded cell is strongly dependent on $R_n$ and so is the JV curve of a module with one shaded cell.

First the JV curve of the fully illuminated module is measured. The average cell parameters including $R_n$ are determined from that curve. Next the JV curve of the module is recorded while shading one cell. The values of $R_n$ of the shaded cell are obtained with a curve fitting procedure. The light induced current of the shaded cell $J_L$, shaded cell =0 and only $R_n$ of the shaded cell must be adapted for obtaining a proper fit. The average values of $R_1$ and $R_3$ and the values of $R_1$ and $R_3$ of the shaded cell that result from the fitting procedure are listed in Table 1.

Table 1: Values of $R_1$ and $R_3$ that are derived from the curve fitting procedure

|  | $R_{1, average}$ | $R_{3, average}$ | $R_{1, ceil 4}$ | $R_{3, cell 4}$ |
|---|---|---|---|---|
| Before Laser treatment | 20,000 | 2,000,000 | 6,000 | 66,000 |
| After Laser treatment | 3,500 | 20,000 | 2,500 | 13,500 |

The decrease of the average value of $R_1$ is realistic, that of the average value of $R_3$ is more or less arbitrarily because the calculated curve of the fully illuminated module is hardly influenced by that value. The decrease of $R_1$ and $R_3$ of the shaded cell are determined with acceptable accuracy. $R_5$ does not play an important role for fitting the relevant part of the JV curves as long as the value of $R_5$ is chosen sufficiently large.

The values of $R_1$ and $R_3$ of the individual cells can be used for characterizing the quality of the laser treatment process. A range of values for proper operating cells can be defined for both parameters: $R_1>1000$, in particular $R_1>2000$; $1000<R_3<50000$, in particular $10000<R_3<50000$ (those values may be changed).

Table 2 shows J-V curves of an eight cells module. The first column gives the module voltage. The second and third columns give the module current and the voltage over one cell respectively versus the module voltage (without shading). The fourth and the fifth columns give the module current and the voltage over the shaded standard cell versus the module voltage (one cell shaded). The sixth and the seventh columns give the module current and the voltage over the shaded cell with conducting spots versus the module voltage (one cell shaded).

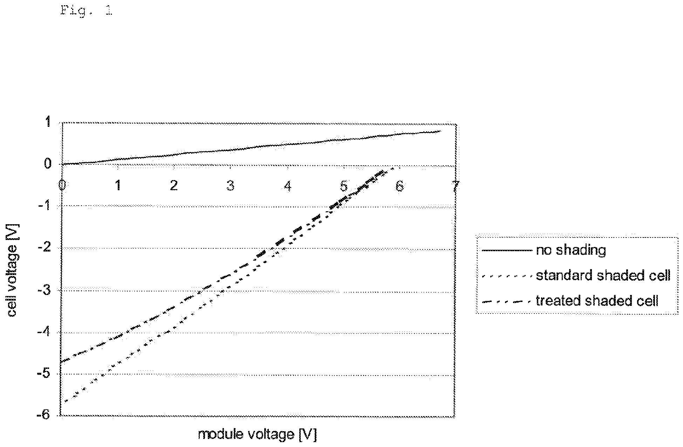

Fig.1 gives a graphical representation of the voltage of a single cell versus the voltage of an eight cell module (numerical data given in Table 2).

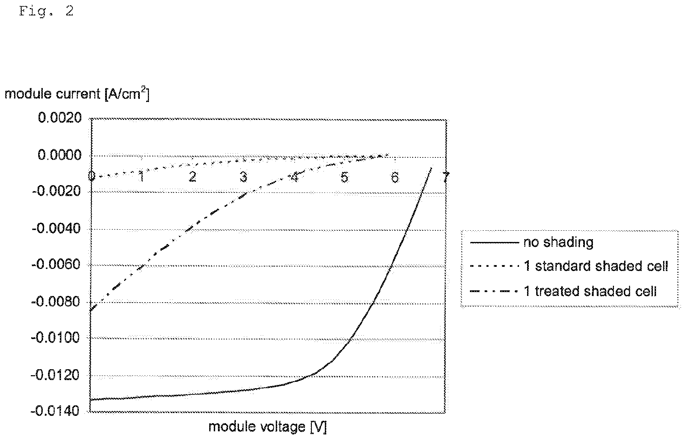

Fig. 2 gives the JV curves of the eight cell module, showing the current of the module versus the voltage of the module (numerical data given in Table 2).

It is obvious that the reverse voltage over a shaded cell with the conducting spots is limited whereas the voltage over a shaded standard cell increases almost linearly with the module voltage.

Table 2

| $V_{module}$ | cells J[A/cm²] | shaded Vcell [V] | not treated | | treated | |
| --- | --- | --- | --- | --- | --- | --- |
| | | | one cell J[A/cm²] | shaded $Vsh_{Cell}$ [V] | one cell J[A/cm²] | shaded $V_{sh\ cell}$ [V] |
| | -0.01333 | 0.000 | -0.00133 | -5.753 | -0.00858 | -4.72066 |
| 0.32 | -0.01329 | 0.040 | -0.00116 | -5.445 | -0.00777 | -4.53519 |
| 0.64 | -0.01325 | 0.080 | -0.00101 | -5.136 | -0.00697 : | -4.33839 |
| 0.96 | -0.01321 | 0.120 | -0.00088 | -4.826 | -0.00619 | -4.13143 |
| 1.28 | -0.01316 | 0.160 | -0.00076 | -4.515 | -0.00545 | -3.91506 |
| 1.6 | -0.01311 | 0.200 | -0.00065 | -4.203 | -0.00474 | -3.68978 |
| 1.92 | -0.01305 | 0.240 | -0.00054 | -3.964 | -0.00407 | -3.45636 |
| 2.24 | -0.01299 | 0.280 | -0.00045 | -3.654 | -0.00346 | -3.21435 |
| 2.56 | -0.01292 | 0.320 | -0.00037 | -3.343 | -0.0029 | -2.96425 |
| 2.88 | -0.01284 | 0.360 | -0.0003 | -3.030 | -0.00239 | -2.70627 |
| 3.2 | -0.01274 | 0.400 | -0.00025 | -2.715 | -0.00194 | -2.44065 |
| 3.52 | -0.01262 | 0.440 | -0.0002 | -2.397 | -0.00154 | -2.16766 |
| 3.84 | -0.01246 | 0.480 | -0.00015 | -2.078 | -0.0012 | -1.88769 |
| 4.16 | -0.01221 | 0.520 | -0.00012 | -1.755 | -0.00091 | -1.60124 |
| 4.48 | -0.0118 | 0.560 | -8.4E-05 | -1.431 | -0.00067 | -1.30893 |
| 4.8 | -0.01113 | 0.600 | -5.7E-05 | -1.105 | -0.00047 | -1.01159 |
| 4.96 | -0.01067 | 0.620 | -4.6E-05 | -0.942 | -0.00039 | -0.86132 |
| 5.12 | -0.01012 | 0.640 | -3.6E-05 | -0.780 | -0.00031 | -0.71015 |
| 5.28 | -0.00947 | 0.660 | -2.7E-05 | -0.620 | -0.00023 | -0.55822 |
| 5.44 | -0.00874 | 0.680 | -1.6E-05 | -0.465 | -0.00017 | -0.40568 |
| 5.6 | -0.00792 | 0.700 | -3.5E-06 | -0.311 | -0.0001 | -0.25265 |
| 5.76 | -0.00704 | 0.720 | 9.18E-06 | -0.157 | -3.9E-05 | -0.09932 |
| 5.92 | -0.00609 | 0.740 | 2.08E-05 | -0.005 | | |
| 6.08 | -0.00508 | 0.760 | | | | |
| 6.24 | -0.00402 | 0.780 | | | | |
| 6.4 | -0.00292 | 0.800 | | | | |
| 6.56 | -0.00177 | 0.320 | | | | |
| 6.72 | -0.00059 | 0.840 | | | | |

## Claims

1.  Photovoltaic (PV) module comprising a plurality of thin film photovoltaic cells, each cell containing a substrate, a transparent conductor electrode layer, a photovoltaic layer, and a back-electrode layer, wherein the photovoltaic layer comprises at least one p-i-n or n-i-p silicon layer, **characterized in that** said silicon layer comprises 10 to 1000 conducting spots of recrystallized silicon per cm², each having independently a surface of 10 to 2500 $\mu m^2$, wherein the conducting spots act as non-linear conducting paths between the two electrode layers and wherein, at a voltage of 1V or less, the conductive spots conduct a current per unit of surface of less than 0.2 mA/cm², and at a voltage of 8V or more, the conductive spots conduct a current per unit of surface of more than 10 mA/cm².

2.  The PV module of claim 1 wherein the silicon layer comprises 20 to 500 conducting spots per cm², preferably 30 to 300 conducting spots per cm², more preferably 80 to 120 conducting spots per cm².

3. The PV module of claim 1 or 2 wherein the conducting spots have a surface of 30 to 300 $\mu m^2$, preferably 50-150 $\mu m^2$, more preferably 60 to 120 $\mu m^2$.

4. A method for making the PV module of any one of claims 1-3 wherein the p-i-n or n-i-p silicon layer is locally heated at 10 to 1000 spots per $cm^2$, each spot having independently a surface of 10 to 2500 $\mu m^2$, whereby the p-i-n or n-i-p silicon is transformed at these spots to form conductive spots, wherein, at a voltage of 1V or less, the conductive spots conduct a current per unit of surface of less than 0.2 mA/cm2, and at a voltage of 8V or more, the conductive spots conduct a current per unit of surface of more than 10 mA/cm2.

5. The method according to claim 4 wherein the heating is performed by a pulsed laser.

6. The method according to claim 5 wherein the heating is performed by a frequency doubled Nd-YAG, Nd-YLF, or Nd-V04 laser with a wavelength $\lambda$ between 520 and 550 nm and a pulse duration less than 50 ns.

## Patentansprüche

1. Photovoltaik- (PV) -Modul, aufweisend eine Mehrzahl von Dünnschicht-Photovoltaikzellen, wobei jede Zelle ein Substrat, eine transparente Leiter-Elektrodenschicht, eine Photovoltaikschicht und eine Rückelektrodenschicht aufweist, wobei die Photovoltaikschicht mindestens eine p-i-n- oder n-i-p-Siliciumschicht aufweist, **dadurch gekennzeichnet, dass** die Siliciumschicht 10 bis 1000 leitende Punkte von rekristallisiertem Silicium pro $cm^2$ aufweist, wobei jeder davon unabhängig eine Fläche von 10 bis 2500 $\mu m^2$ hat, wobei die leitenden Punkte als nicht-lineare Leiterbahnen zwischen den beiden Elektrodenschichten dienen, und wobei bei einer Spannung von 1V oder weniger die leitfähigen Punkte einen Strom pro Oberflächeneinheit von weniger als 0,2 mA/cm$^2$ leiten, und bei einer Spannung von 8V oder mehr die leitfähigen Punkte einen Strom pro Oberflächeneinheit von mehr als 10 mA/cm$^2$ leiten.

2. Das PV-Modul gemäß Anspruch 1, wobei die Siliciumschicht 20 bis 500 leitende Punkte pro $cm^2$, vorzugsweise 30 bis 300 leitende Punkte pro $cm^2$, noch bevorzugter 80 bis 120 leitende Punkte pro $cm^2$ aufweist.

3. Das PV-Modul gemäß Anspruch 1 oder 2, wobei die leitenden Punkte eine Oberfläche von 30 bis 300 $\mu m^2$, vorzugsweise von 50 bis 150 $\mu m^2$, noch bevorzugter von 60 bis 120 $\mu m^2$ haben.

4. Ein Verfahren zum Herstellen des PV-Moduls gemäß irgendeinem der Ansprüche 1 bis 3, wobei die p-i-n- oder n-i-p-Siliciumschicht an 10 bis 1000 Punkten pro $cm^2$ lokal erhitzt wird, wobei jeder Punkt unabhängig eine Fläche von 10 bis 2500 $\mu m^2$ hat, wodurch das p-i-n- oder n-i-p-Silicium an diesen Punkten umgewandelt wird, um leitfähige Punkte auszubilden, wobei bei einer Spannung von 1V oder weniger die leitfähigen Punkte einen Strom pro Oberflächeneinheit von weniger als 0,2 mA/cm$^2$ leiten und bei einer Spannung von 8V oder mehr die leitfähigen Punkte einen Strom pro Oberflächeneinheit von mehr als 10 mA/cm$^2$ leiten.

5. Das Verfahren gemäß Anspruch 4, wobei das Erhitzen mittels eines gepulsten Lasers erfolgt.

6. Das Verfahren gemäß Anspruch 5, wobei das Erhitzen mit einem Frequenz-gedoppelten Nd-YAG-, Nd-YLF- oder Nd-V04-Laser mit einer Wellenlänge $\lambda$ zwischen 520 und 550 nm und einer Pulsdauer von weniger als 50 ns durchgeführt wird.

## Revendications

1. Module photovoltaïque (PV) comprenant une pluralité de cellules photovoltaïques en couche mince, chaque cellule contenant un substrat, une couche d'électrode conductrice transparente, une couche photovoltaïque, et une couche de contre-électrode, dans lequel la couche photovoltaïque comprend au moins une couche de silicium p-i-n ou n-i-p, **caractérisé en ce que** ladite couche de silicium comprend 10 à 1 000 points conducteurs de silicium recristallisé par cm$^2$, chacun ayant indépendamment une surface de 10 à 2 500 $\mu m^2$, dans lequel les points conducteurs agissent comme chemins conducteurs non linéaires entre deux couches d'électrode et dans lequel, à une tension de 1 V ou moins, les points conducteurs conduisent un courant par unité de surface inférieur à 0,2 mA/cm$^2$, et à une tension de 8 V ou plus, les points conducteurs conduisent un courant par unité de surface supérieur à 10 mA/cm$^2$.

2. Module PV selon la revendication 1, dans lequel la couche de silicium comprend 20 à 500 points conducteurs par

cm$^2$, de préférence 30 à 300 points conducteurs par cm$^2$, plus préférentiellement 80 à 120 points conducteurs par cm$^2$.

**3.** Module PV selon la revendication 1 ou 2, dans lequel les points conducteurs ont une surface de 30 à 300 $\mu$m$^2$, de préférence de 50 à 150 $\mu$m$^2$, plus préférentiellement de 60 à 120 $\mu$m$^2$.

**4.** Procédé de fabrication du module PV selon l'une quelconque des revendications 1 à 3, dans lequel la couche de silicium p-i-n ou n-i-p est chauffée localement au niveau de 10 à 1 000 points par cm$^2$, chaque point ayant indépendamment une surface de 10 à 2 500 $\mu$m$^2$, moyennant quoi le silicium p-i-n ou n-i-p est transformé au niveau de ces points afin de former des points conducteurs, dans lequel, à une tension de 1 V ou moins, les points conducteurs conduisent un courant par unité de surface inférieur à 0,2 mA/cm$^2$, et à une tension de 8 V ou plus, les points conducteurs conduisent un courant par unité de surface supérieur à 10 mA/cm$^2$.

**5.** Procédé selon la revendication 4, dans lequel le chauffage est réalisé par un laser pulsé.

**6.** Procédé selon la revendication 5, dans lequel le chauffage est réalisé par un laser double fréquence Nd-YAG, Nd-YLF ou Nd-V04 avec une longueur d'ondes $\lambda$ située entre 520 et 550 nm et une durée de l'impulsion inférieure à 50 ns.

Fig. 1

module voltage [V]

Fig. 2

module current [A/cm$^2$]

module voltage [V]

——— no shading

········ 1 standard shaded cell

—··—· 1 treated shaded cell

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5223044 A
- WO 2005101511 A
- US 20030159728 A
- EP 1079441 A
- US 5810945 A

### Non-patent literature cited in the description

- **D. TOET et al.** *Thin solid films,* 1977, vol. 296, 49-52
- Hot spot test for crystalline silicon modules. **J. WOHLGEMUTH ; W. HERRMANN.** Photovoltaic Specialists Conference. IEEE, 03 January 2005, 1062-1063
- **S.R. WENHAM et al.** *Applied Photovoltaics,* ISBN 0 36758 909 4, 33